# EUROPEAN PATENT APPLICATION

(11) **EP 2 634 919 A1**
(43) Date of publication of application: **04.09.2013**
(21) Application number: 12157553.4
(22) Date of filing: 29.02.2012
(51) Int. Cl.: H03K 3/03, H03K 19/0185

(54) **Level shifter, oscillator circuit using the same and method**

(71) Applicant: NXP B.V., 5656 AG Eindhoven (NL)
(72) Inventor: van den Boom, Jeroen, Redhill, Surrey RH1 1DL (GB)
(74) Representative: Crawford, Andrew

(57) **Abstract**

A level shifter for a set of at least three phase-shifted signals is disclosed. The level shifter comprises an odd plural number of inverters arranged in a ring. A supply terminal of each inverter is coupled to a supply rail via a respective switching device, which is controlled by the phase-shifted signals.

## Description

The invention relates to a level shifter and to an oscillator comprising the level shifter as a readout circuit.

Oscillators, such as ring oscillators, are commonly used in Phase-Locked Loops (PLL), which are widely-used for clock and data recovery and frequency multiplication. The jitter performance of a PLL is critical. In many applications such as telecommunication and data conversion clocking, the jitter requirements are becoming increasingly stringent in order to meet the demands for narrower channel spacing, lower distortion and higher bit rates amongst other criteria. Other important requirements are a low current consumption, in particular for portable applications, and a small chip area.

A necessary condition for a low jitter is that the oscillator phase noise must be low. For integrated oscillators (i.e. those without external components), the preferred type is the ring oscillator, which consists of an odd number of inverters in a loop. A current is supplied by a current source to the inverters in the loop to control the oscillator frequency.

The sub-micron CMOS processes typically used at present have digital supply voltages ranging from 1.8V down to 1V or even lower. The voltage at the outputs of the inverters in the ring oscillator swings between 0V and a value that depends on the inverter transistor dimensions and the frequency of operation. Typically, this voltage is around one threshold voltage, which is considerably lower than the supply voltage. The remaining fraction (i.e. the supply voltage minus the threshold voltage) is necessary as headroom for the current source supplying the inverters. However, the amplitude of the output signal from the oscillator is required to be equal to the digital supply voltage. A readout circuit fulfils the function of amplifying the oscillator output signal.

A simple readout technique uses a series of inverters AC-coupled to the ring oscillator to amplify the output of one of the ring oscillator's inverters. A feedback resistor between input and output of the first inverter defines the input DC level. Alternatively, the oscillator signal can be amplified using a DC-coupled circuit.

The AC-coupled and the DC-coupled readout circuits have several disadvantages. For example, the AC-coupled circuit, the signals at the outputs of the ring oscillator's inverters are analogue, having sloping edges, and are therefore vulnerable to external noise sources such as substrate bounce. The signals also contain 1/f and thermal noise from the oscillator and current source components. The AC-coupled readout circuit is in fact an amplifier with a very high bandwidth so all noise present at the ring oscillator output will propagate unfiltered to the output signal in the form of jitter. Both readout circuits load the oscillator asymmetrically. This has an adverse effect on jitter performance.

According to the invention, there is provided an apparatus and method as defined in the independent claims.

In a first aspect, the invention provides a level shifter for a set of at least three phase-shifted signals, the level shifter comprising a ring oscillator structure with an odd plural number of inverters arranged in a ring with the output of each inverter coupled to the input of the next inverter in the ring, wherein the level shifter further comprises a control circuit comprising an identical input for receiving each of the set of at least three phase-shifted signals and being adapted to constrain the switching frequency of the ring oscillator structure to the frequency of oscillation of the set of at least three phase-shifted signals.

The impedance seen at each of the level shifter inputs is the same because each of the inputs is identical. Thus, the invention provides a level shifter that can provide symmetrical loading of a ring oscillator or other circuit producing the series of phase-shifted signals.

By a set of phase-shifted signals is meant a set of signals where each signal is simply a phase-shifted version of the other signals in the set. For example, in a ring oscillator successive signals in the ring will be offset in phase by 180° plus an amount of phase shift that depends on the delay through the inverter.

The outputs of the inverters in the ring oscillator structure are generally able to switch over a larger voltage range than the set of at least three phase-related signals. This may be achieved by providing the supply terminals of each inverter with a larger supply voltage than the magnitude of the set of at least three phase-related signals.

The control circuit preferably comprises a respective switching device coupled between a supply terminal of each inverter and a supply rail, each switching device being controlled by a respective one of the set of phase-shifted signals.

Each switching device is typically connected between a lower voltage terminal of the respective inverter and a low supply voltage rail, wherein the positive supply terminal of each inverter being coupled to a high supply rail. Thus, the switching devices are for example pull-down devices.

The negative and positive supply rails are normally coupled to negative and positive supply terminals of an integrated circuit in which the level shifter is integrated.

In a preferred embodiment, each of the switching devices is identical. This is one convenient way of ensuring that the impedance of each of the level shifter inputs is the same so that each output of an oscillator or other circuit coupled to the level shifter is symmetrically loaded. Alternatively, resistive padding may be used to adjust each level shifter input to have the same impedance.

Each of the switching devices can be a transistor. For example, the transistors may be **MOSFET_{S}.**

The level shifter may further comprise an additional inverter with its input coupled to the output of one of the inverters arranged in the ring and its output coupled to an output terminal of the level shifter. This provides a further buffer before the level shifter output. In alternative embodiments, the output of any one of the inverters arranged in the ring could form the output terminal of the level shifter.

The level shifter may further comprise a frequency divider coupled to an output from the level shifter. The frequency divider typically divides the output from the level shifter by two. A flip-flop is normally used to implement the frequency divider.

In accordance with a second aspect of the invention, there is provided an oscillator arrangement comprising a ring oscillator formed from an odd plural number of inverters arranged in a ring with the output of each inverter coupled to the input of the next inverter in the ring; and a readout circuit comprising a level shifter according to the first aspect of the invention, wherein the output of each inverter in the ring oscillator comprises a respective one of the phase-shifted signals and is coupled to a respective input of the control circuit.

The ring oscillator can comprise a current source between a high voltage rail and the high voltage terminal of each inverter of the ring oscillator. The level shifter thus enables an output to be provided which does not need the large headroom required by the ring oscillator.

A third aspect of the invention provides a method of level shifting a set of phase-shifted signals, comprising:
providing a ring oscillator structure with an odd plural number of inverters arranged in a ring with the output of each inverter coupled to the input of the next inverter in the ring;
receiving each of the set of at least three phase-shifted signals; and
constraining the switching frequency of the ring oscillator structure to the frequency of oscillation of the set of at least three phase-shifted signals.

This method essentially uses phase signals (such as the signals from a ring oscillator) to constrain the frequency cycling of a level shifter which has the form of a ring oscillator. The ring oscillator structure is voltage biased rather than current driven so that the full voltage headroom is available at the output of the ring oscillator structure.

In another aspect, there is a method of providing an output from a ring oscillator, wherein the ring oscillator typically comprises an odd plural number of inverters arranged in a ring with the output of each inverter coupled to the input of the next inverter in the ring, wherein the method comprises:
performing the level shifting method of the third aspect by providing the output of each inverter in the ring oscillator, as a respective one of the phase-shifted signals, to a respective input of a control circuit adapted to constrain the switching frequency of the ring oscillator structure to the frequency of oscillation of the set of at least three phase-shifted signals.

The method may further comprise controlling the frequency of oscillation of the ring oscillator by adjusting a supply current to the ring oscillator.

An example of the invention will now be described in detail with reference to the accompanying drawings, in which:
Figure 1 shows a level shifter according to the invention coupled to a ring oscillator;
Figure 2 shows the waveforms at various nodes of the circuit of Figure 1; and
Figures 3 and 4 show alternative forms of oscillator for use with the level shifter.

The invention provides a level shifter for a set of at least three phase-shifted signals. The level shifter is formed as a ring of inverters. A supply terminal of each inverter is coupled to a supply rail via a respective switching device, each switching device being controlled by a respective one of the three phase-shifted signals. This means the level shifter does not oscillate freely - instead the timing of signals passing around the loop is controlled by the phase-shifted signals. Each phase-shifted signal is connected to a switching device of the level shifter so that the same level shifter impedances are "seen" by each of the phase related signals.

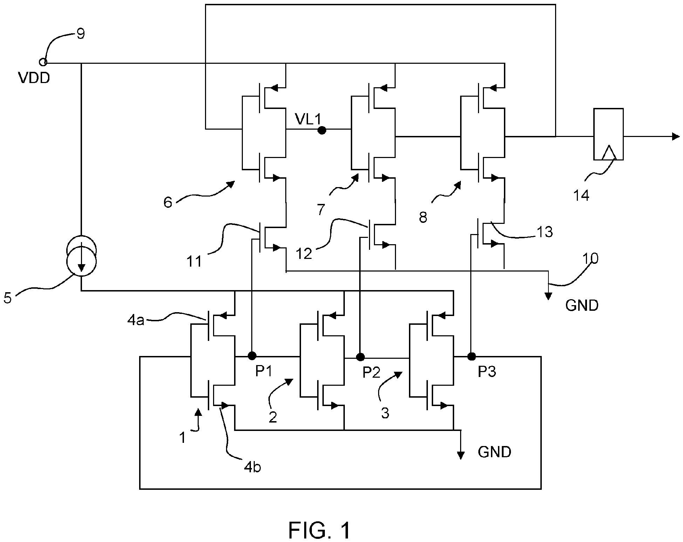

In Figure 1, a ring oscillator is formed from three inverters 1, 2, 3. Each inverter is formed in the usual way from a P-channel and an N-channel MOSFET coupled together between positive and negative supply rails. Thus, inverter 1 is formed from a P-channel MOSFET 4a with its source coupled to the drain of N-channel MOSFET 4b, the source of which is coupled to a negative supply rail, in this case 0V. The gates of MOSFETs 4a, 4b are coupled together and act as an input to the inverter, the output being taken from the junction between the source of MOSFET 4a and the drain of MOSFET 4b.

The inverters 2, 3 are identical in construction to inverter 1. The output of inverter 1 is coupled to the input of inverter 2, and the output of inverter 2 is coupled to the input of inverter 3. The output of inverter 3 is coupled to the input of inverter 1. A current source 5 supplies power to the inverters 1, 2, 3 in the ring oscillator. The magnitude of the current can be varied to adjust the frequency of oscillation.

The voltage drop across the current source from the supply voltage VDD means that the outputs of the inverters have a relatively small voltage swing. For example with a value of 2V for VDD, the inverter outputs typically swing between 0V and 700mV.

It is known to use a level shifter circuit to boost the oscillator output to swing fully between the supply voltage rails (0V and 2V in this example).

This invention relates to an improved level shifter circuit.

The level shifter or readout circuit is shown in the upper part of Figure 1. This comprises three inverters 6, 7, 8, each of which is constructed from a P-channel and an N-channel MOSFET in identical fashion to inverters 1, 2, 3. The output of inverter 6 is coupled to the input of inverter 7, the output of which is coupled to the input of inverter 8. The output of inverter 8 is coupled to the input of inverter 6.

A positive supply terminal 9 is coupled to the drains of the P-channel MOSFETs of each inverter 6, 7, 8. The sources of each of the N-channel MOSFETs of each inverter 6, 7, 8 are coupled to a negative supply terminal 10 (0V) via respective switchable pull-down transistors 11, 12, 13. The switchable pull-down transistors 11, 12, 13 are N-channel MOSFETs. Rather than being supplied by a current source (as with the ring oscillator formed by inverters 1, 2, 3), the level shifter is therefore supplied by a voltage source (VDD). This means there is no loss of voltage headroom, and the output voltages of the inverters can swing across the full voltage range.

The gates of the N-channel MOSFETs making up the switchable pull-down transistors 11, 12, 13 are each connected to a respective output of inverters 1, 2, 3. Thus, each switchable pull-down transistor 11, 12, 13 is switched in response to the set of phase-shifted signals generated at the outputs of the ring oscillator's inverters 1, 2, 3.

The level shifter has the same number of inverters as the ring oscillator, so that each ring oscillator phase signal connects to a respective level shifter inverter chain, with a one-to-one mapping. This means that all phase signals are influenced in the same way, and the contribution of the level shifter circuit to the total jitter is minimised.

This arrangement means that the pull down function of the n-type transistor of each inverter stage is disabled if the respective additional pull-down transistor 11, 12, 13 is not turned on. This means the level shifter circuit, which has the form of a free-running ring oscillator, is not free to oscillate at its normal frequency. Instead, the pull-down transistors 11, 12, 13 operate to tie the oscillating frequency of the level shifter to the oscillating frequency of the ring oscillator. The pull-down transistors delay each inverter stage output from switching from high to low until the respective pull-down transistor has been switched on.

The inverters 6, 7, 8 in the level shifter should be faster than the inverters 1, 2, 3 of the ring oscillator so that they may follow the signal from the ring oscillator and amplify it to a larger voltage swing. The slew rate of inverters 6, 7, 8 should be as fast as possible to produce the steepest possible output slope in order to minimize their jitter contribution and also to minimize the sensitivity to external noise sources like electromagnetic interference (EMI) and substrate bounce. In practice, the channel length of the transistors in the inverters 6, 7, 8 and the pull-down transistors 11, 12, 13 should be as short as possible to maximize speed. The product of the width and length of the channels of pull-down transistors 11, 12, 13 should preferably be less than the width and length product of the channels of the transistors in the ring oscillator inverters 1, 2, 3 to minimize capacitive loading on the ring oscillator.

The level shifter formed from inverters 6, 7, 8 and switchable pull-down transistors 11, 12, 13 amplifies the output signals from the inverters 1, 2, 3 of the ring oscillator. An output may be taken from the level shifter at the output of any of the inverters 6, 7, 8. However, usually, the output taken from the level shifter will be coupled to the input of an inverter or a collection of inverters arranged in series (i.e. with the output of one inverter coupled to the input of a successive inverter in the series) to buffer and further amplify the output signal from the level shifter. The output from the inverter or collection of inverters forms the overall output of the level shifter circuit.

The duty cycle of the output signal from the level shifter differs from 50%. This is because of the delay introduced only to the pull-down operation of the inverters of the level shifter. The output signal can be coupled to a flip-flop to divide the output signal frequency by two in order to achieve an almost exact 50% duty cycle. This is shown schematically as 14 in Figure 1.

Due to the use of switchable pull-down transistors 11, 12, 13 the output signal has a slow falling edge and a fast rising edge. Therefore, the flip-flop 14 should preferably trigger on the rising edge rather than the falling edge.

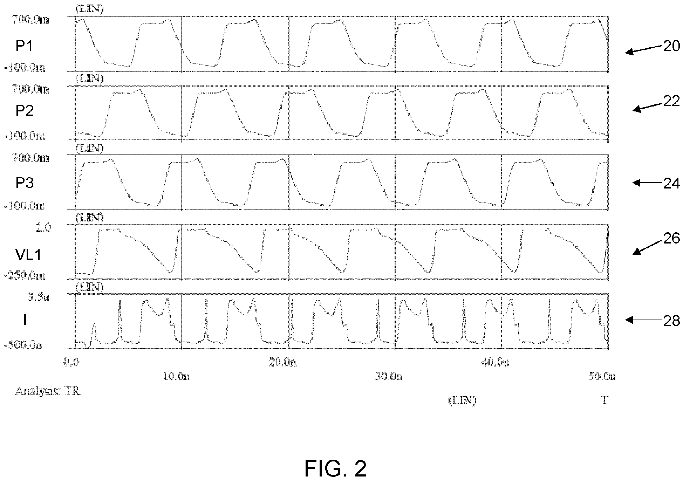

Figure 2 shows the waveforms at various points of the circuit. The outputs from inverters 1, 2, 3 (i.e. the outputs from the ring oscillator) are shown at graphs 20, 22, 24 respectively, and these correspond to the nodes labelled P1, P2 and P3 (phases 1 to 3) in Figure 1.

As expected, the output from inverter 2 (graph 22) is effectively a simple delayed inversion of the output from inverter 1 (graph 20). The output from inverter 3 (graph 24) is effectively a delayed inversion of the output from inverter 2.

As explained above, the inverter outputs swing from 0V to 700mV.

The output from inverter 6 (i.e. one possible output from the level shifter) is shown at graph 26 corresponding to node VL1 in Figure 1. The output from inverter 7 is not shown because it is simply an inverted and delayed version of the output from inverter 6. Similarly, the output from inverter 8 is not shown because it is simply another delayed inverted version of the output from inverter 7. The total delay in this case amounts to 180 degrees, i.e. there is a 60 degree delay at each inverter.

Graph 28 shows the current flowing through from positive terminal 9, through inverter 6 and switchable pull-down transistor 11 to the negative terminal 10. The main current conduction takes place in time with phase P1 which corresponds to the pull-down transistor 11 being turned on.

The level shifter circuit is capable of giving a lower jitter contribution to the output signal than the prior art circuits described above. General information theory predicts that the signal-to-noise ratio of a signal improves when all signal information is used. The readout circuits described above ignore the signal information available at one output node (at least) of a ring oscillator. The level shifter circuit of Figure 1, on the other hand, uses all available phase information of the signal and therefore has a better signal-to-noise ratio.

The circuit shown in Figure 1 only has three stages. However, this is arbitrary and any plural odd number of inverter stages could be used, each with a respective switchable pull-down device. For example, if the ring oscillator had five or seven inverter stages then the level shifter circuit would have five or seven stages respectively.

As mentioned above, the pull-up function of each inverter stage of the level shifter can instead be enabled/disabled by using a pull-up switching device.

The invention has been described in connection with a current supplied ring oscillator. The invention can however be used with other circuits that produce sets of phase-shifted signals, for example a circuit producing signals in quadrature. The invention basically provides an oscillator that is constrained to follow the frequency defined by the phase-shifted signals provided to it, but allows full voltage swing output and has an equal effect on each of the phase-shifted signals.

In the example above, the number of inverters of the level shifter is matched to the number of inverters of the ring oscillator.

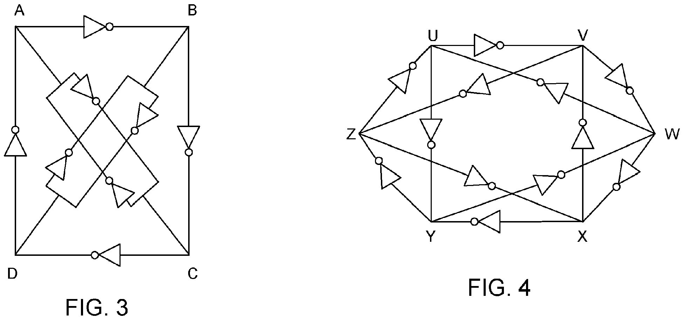

Figures 3 and 4 show alternative oscillator structures that may be used with the level shifter shown in Figure 1. For example, in Figure 3, a quadrature oscillator structure that is a combination of 4 interwoven ring oscillators each consisting of 3 inverters is shown. This can be coupled to a level shifter similar to that of Figure 1 but with four inverters in the ring, each output (A, B, C, D) of the oscillator in Figure 3 being coupled to a respective input of the level shifter. Figure 4 shows a 6-phase oscillator with 6 interwoven ring oscillators, each consisting of 3 inverters. This can be coupled to a level shifter similar to that of Figure 1 but with six inverters in the ring, each output (U, V, W, X, Y, Z) of the oscillator in Figure 4 being coupled to a respective input of the level shifter. This structure can be generalized to a higher even number (e.g. 8, 10, 12) of interwoven oscillators.

Other variations to the disclosed embodiments can be understood and effected by those skilled in the art in practising the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A level shifter for a set of at least three phase-shifted signals (P1, P2, P3), the level shifter comprising a ring oscillator structure with an odd plural number of inverters (6, 7, 8) arranged in a ring with the output of each inverter coupled to the input of the next inverter in the ring, wherein the level shifter further comprises a control circuit comprising an identical input for receiving each of the set of at least three phase-shifted signals and being adapted to constrain the switching frequency of the ring oscillator structure to the frequency of oscillation of the set of at least three phase-shifted signals (P1, P2, P3).

2. A level shifter according to claim 1, wherein the control circuit comprises a respective switching device (11, 12, 13) coupled between a supply terminal of each inverter and a supply rail (10), each switching device being controlled by a respective one of the set of phase-shifted signals (P1, P2, P3).

3. A level shifter according to claim 1, wherein each switching device (11, 12, 13) is connected between a lower voltage terminal of the respective inverter and a low supply voltage rail, wherein the positive supply terminal of each inverter being coupled to a high supply rail (9).

4. A level shifter according to claim 3, wherein the low and high supply rails are coupled to supply terminals of an integrated circuit in which the level shifter is integrated.

5. A level shifter according to any of the preceding claims, wherein each of the switching devices (11, 12, 13) is identical.

6. A level shifter according to any of the preceding claims, wherein each of the switching devices (11, 12, 13) is a transistor.

7. A level shifter according to any of the preceding claims, further comprising an additional inverter with its input coupled to the output of one of the inverters (6, 7, 8) arranged in the ring and its output coupled to an output terminal of the level shifter.

8. A level shifter according to any of the preceding claims, further comprising a frequency divider (14) coupled to an output from the level shifter.

9. A level shifter according to claim 8, wherein the frequency divider (14) divides the output from the level shifter by two.

10. An oscillator arrangement comprising:
a ring oscillator formed from an odd plural number of inverters (1, 2, 3) arranged in a ring with the output of each inverter coupled to the input of the next inverter in the ring; and
a readout circuit comprising a level shifter according to any of claims 1 to 9, wherein the output (P1, P2, P3) of each inverter (1, 2, 3) in the ring oscillator comprises a respective one of the phase-shifted signals and is coupled to a respective input of the control circuit.

11. An oscillator as claimed in claim 10, wherein the ring oscillator has the same number of inverters as the level shifter.

12. An oscillator arrangement as claimed in claim 10 or 11, wherein the ring oscillator comprises a current source (5) between a high voltage rail (9) and the high voltage terminal of each inverter (1,2,3) of the ring oscillator.

13. A method of level shifting a set of phase-shifted signals, comprising:
providing a ring oscillator structure with an odd plural number of inverters (6, 7, 8) arranged in a ring with the output of each inverter coupled to the input of the next inverter in the ring;
receiving each of the set of at least three phase-shifted signals; and
constraining the switching frequency of the ring oscillator structure to the frequency of oscillation of the set of at least three phase-shifted signals (P1, P2, P3).

14. A method of providing an output from a ring oscillator, wherein the ring oscillator comprises an odd plural number of inverters (1, 2, 3) arranged in a ring with the output of each inverter coupled to the input of the next inverter in the ring, wherein the method comprises:
performing the level shifting method of claim 13 by providing the output (P1, P2, P3) of each inverter (1, 2, 3) in the ring oscillator, as a respective one of the phase-shifted signals, to a respective input of a control circuit adapted to constrain the switching frequency of the ring oscillator structure to the frequency of oscillation of the set of at least three phase-shifted signals.

15. A method of providing an output from a ring oscillator according to claim 13 or 14, further comprising controlling the frequency of oscillation of the ring oscillator by adjusting a supply current to the ring oscillator.
